(19)

Europäisches
Patentamt
European
Patent Office
Office européen
des brevets

(11)  **EP 3 404 728 A1**

(12)  **EUROPEAN PATENT APPLICATION**
published in accordance with Art. 153(4) EPC

(43) Date of publication:
**21.11.2018 Bulletin 2018/47**

(21) Application number: **17738557.2**

(22) Date of filing: **13.01.2017**

(51) Int Cl.:
*H01L 35/22* (2006.01)   *B82Y 30/00* (2011.01)
*B82Y 40/00* (2011.01)   *C01B 32/152* (2017.01)
*C01B 32/158* (2017.01)   *H01L 35/24* (2006.01)
*H01L 35/26* (2006.01)   *H01L 35/34* (2006.01)
*H01L 51/00* (2006.01)   *H01L 51/30* (2006.01)
*H01L 51/40* (2006.01)

(86) International application number:
**PCT/JP2017/001092**

(87) International publication number:
**WO 2017/122805 (20.07.2017 Gazette 2017/29)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**MA MD**

(30) Priority: **15.01.2016   JP 2016006454**

(71) Applicants:
• **Zeon Corporation**
  **Tokyo 100-8246 (JP)**
• **Public University Corporation Tokyo University of**
  **Science, Sanyo Onoda Yamaguchi**
  **Yamauchi 7560884 (JP)**

(72) Inventors:
• **TOSHIMA Naoki**
  **Tokyo 175-0045 (JP)**
• **SHIRAISHI Yukihide**
  **Tokyo 162-8601 (JP)**
• **ASANO Hitoshi**
  **Tokyo 162-8601 (JP)**
• **OSHIMA Keisuke**
  **Bungo-ohno-shi**
  **Oita 879-7152 (JP)**
• **INOUE Junta**
  **Fujieda-shi**
  **Shizuoka 426-0006 (JP)**

(74) Representative: **Maiwald Patent- und
Rechtsanwaltsgesellschaft mbH
Elisenhof
Elisenstraße 3
80335 München (DE)**

(54)  **COMPOSITION FOR THERMOELECTRIC CONVERSION ELEMENT, METHOD FOR PRODUCING CARBON NANOTUBES THAT CARRY METAL NANOPARTICLES, MOLDED BODY FOR THERMOELECTRIC CONVERSION ELEMENT AND METHOD FOR PRODUCING SAME, AND THERMOELECTRIC CONVERSION ELEMENT**

(57)      A composition for a thermoelectric conversion element that enables a thermoelectric conversion element to fully exhibit excellent thermoelectric conversion characteristics is provided. A composition for a thermoelectric conversion element comprises: metal nanoparticle-supporting carbon nanotubes, a resin component; and a solvent.

EP 3 404 728 A1

**Description**

TECHNICAL FIELD

The present disclosure relates to a composition for a thermoelectric conversion element, a method of producing metal nanoparticle-supporting carbon nanotubes, a shaped product for a thermoelectric conversion element and a method of producing the same, and a thermoelectric conversion element.

BACKGROUND

There has conventionally been much interest in thermoelectric conversion elements that can directly convert thermal energy to electrical energy. Inorganic materials have been used to produce thermoelectric conversion material layers that serve to perform the energy conversion in thermoelectric conversion elements. In recent years, however, techniques of producing thermoelectric conversion material layers in thermoelectric conversion elements using organic materials containing resin components have been investigated, in terms of excellent processability and flexibility.

For example, JP 2015-170766 A (PTL 1) discloses forming a thermoelectric conversion material layer using a resin composition that contains insulating resin, an inorganic thermoelectric conversion material, and a charge transport material, and discloses using single-walled carbon nanotubes as the inorganic thermoelectric conversion material. According to PTL 1, the use of the resin composition containing the insulating resin, the inorganic thermoelectric conversion material, and the charge transport material enables the production of a thermoelectric conversion element with excellent thermoelectric conversion characteristics.

CITATION LIST

Patent Literatures

PTL 1: JP 2015-170766 A

SUMMARY

(Technical Problem)

However, even with use of the conventional techniques mentioned above, it has been difficult to produce a thermoelectric conversion element having fully excellent thermoelectric conversion characteristics. Thus, there has been still room for improving the conventional techniques in terms of enabling a thermoelectric conversion element including a thermoelectric conversion material layer formed using an organic material to exhibit more excellent thermoelectric conversion characteristics.

(Solution to Problem)

The inventors conducted extensive studies to achieve the object, and focused on carbon nanotubes (hereafter also referred to as "CNTs") used together with a resin component in the conventional techniques. The inventors then discovered that the use of, as a thermoelectric conversion material layer in a thermoelectric conversion element, a shaped product for a thermoelectric conversion element produced using a composition for a thermoelectric conversion element containing metal nanoparticle-supporting carbon nanotubes (hereafter also referred to as "metal-supporting CNTs"), a resin component, and a solvent enables the thermoelectric conversion element to fully exhibit excellent thermoelectric conversion characteristics.

To advantageously solve the problems stated above, a presently disclosed composition for a thermoelectric conversion element comprises: metal nanoparticle-supporting carbon nanotubes; a resin component; and a solvent. By using, as a thermoelectric conversion material layer in a thermoelectric conversion element, a shaped product for a thermoelectric conversion element obtained using such a composition for a thermoelectric conversion element containing metal-supporting CNTs, a resin component, and a solvent, the thermoelectric conversion element can fully exhibit excellent thermoelectric conversion characteristics.

As used herein, "nanoparticles" denote particles having nanometer-scale particle diameters.

Preferably, in the presently disclosed composition for a thermoelectric conversion element, a specific surface area of carbon nanotubes forming the metal nanoparticle-supporting carbon nanotubes is 600 $m^2/g$ or more. By using metal-supporting CNTs formed by CNTs with a specific surface area of 600 $m^2/g$ or more supporting metal nanoparticles, the thermoelectric conversion characteristics of the thermoelectric conversion element can be further enhanced.

Preferably, in the presently disclosed composition for a thermoelectric conversion element, metal nanoparticles supported by carbon nanotubes in the metal nanoparticle-supporting carbon nanotubes include nanoparticles of transition metal. By using CNTs supporting transition metal nanoparticles, the thermoelectric conversion characteristics of the thermoelectric conversion element can be further enhanced.

Further preferably, the transition metal is palladium. By using CNTs supporting palladium nanoparticles, the thermoelectric conversion characteristics of the thermoelectric conversion element can be even further enhanced.

To advantageously solve the problems stated above, a presently disclosed method of producing metal nanoparticle-supporting carbon nanotubes comprises reducing a metal precursor in a mixture that contains at least carbon nanotubes, the metal precursor, and a reductant by the reductant, to obtain metal nanoparticle-supporting carbon nanotubes. By reducing the metal precursor using the reductant to cause the metal nanoparticles to precipitate onto the CNTs, metal-supporting CNTs capable of sufficiently enhancing the thermoelectric conversion characteristics of the thermoelectric conversion element can be produced efficiently.

To advantageously solve the problems stated above, a presently disclosed method of producing metal nanoparticle-supporting carbon nanotubes comprises reducing a metal precursor in a mixture that contains at least carbon nanotubes, the metal precursor, and a reaction solvent by dispersion treatment that brings about a cavitation effect or a crushing effect, to obtain metal nanoparticle-supporting carbon nanotubes. By reducing the metal precursor to cause the metal nanoparticles to precipitate onto the CNTs using the dispersion treatment that brings about a cavitation effect or a crushing effect, metal-supporting CNTs capable of sufficiently enhancing the thermoelectric conversion characteristics of the thermoelectric conversion element can be produced efficiently.

To advantageously solve the problems stated above, a presently disclosed shaped product for a thermoelectric conversion element is formed using any of the above-described compositions for a thermoelectric conversion element. By using, as a thermoelectric conversion material layer in a thermoelectric conversion element, the shaped product for a thermoelectric conversion element obtained using any of the above-described compositions for a thermoelectric conversion element, the thermoelectric conversion element can fully exhibit excellent thermoelectric conversion characteristics.

Preferably, the presently disclosed shaped product for a thermoelectric conversion element has a thickness of 0.05 $\mu$m or more and 100 $\mu$m or less. By using the shaped product for a thermoelectric conversion element with a thickness in the above-mentioned range, the thermoelectric conversion characteristics of the thermoelectric conversion element can be further enhanced while ensuring the strength of the shaped product for a thermoelectric conversion element.

To advantageously solve the problems stated above, a presently disclosed method of producing a shaped product for a thermoelectric conversion element comprises: mixing a coarse mixture that contains metal nanoparticle-supporting carbon nanotubes, a resin component, and a solvent by dispersion treatment that brings about a cavitation effect or a crushing effect, to obtain a composition for a thermoelectric conversion element; and removing the solvent from the composition for a thermoelectric conversion element. By using the shaped product for a thermoelectric conversion element obtained in this way as a thermoelectric conversion material layer in a thermoelectric conversion element, the thermoelectric conversion element can fully exhibit excellent thermoelectric conversion characteristics.

To advantageously solve the problems stated above, a presently disclosed thermoelectric conversion element comprises a thermoelectric conversion material layer including any of the above-described shaped products for a thermoelectric conversion element. By using any of the above-described shaped products for a thermoelectric conversion element as a thermoelectric conversion material layer, the thermoelectric conversion element can fully exhibit excellent thermoelectric conversion characteristics.

(Advantageous Effect)

It is therefore possible to provide a composition for a thermoelectric conversion element that enables a thermoelectric conversion element to fully exhibit excellent thermoelectric conversion characteristics.

It is also possible to provide a method of producing metal nanoparticle-supporting carbon nanotubes that enables a thermoelectric conversion element to fully exhibit excellent thermoelectric conversion characteristics.

It is also possible to provide a shaped product for a thermoelectric conversion element that enables a thermoelectric conversion element to fully exhibit excellent thermoelectric conversion characteristics.

It is also possible to provide a thermoelectric conversion element having fully excellent thermoelectric conversion characteristics.

DETAILED DESCRIPTION

One of the disclosed embodiments is described in detail below.

A presently disclosed composition for a thermoelectric conversion element contains metal nanoparticle-supporting carbon nanotubes, and is used in the formation of a presently disclosed shaped product for a thermoelectric conversion element. The metal nanoparticle-supporting carbon nanotubes used in the presently disclosed composition for a thermoelectric conversion element can be produced using a presently disclosed method of producing metal nanoparticle-supporting carbon nanotubes. The presently disclosed shaped product for a thermoelectric conversion element can be used as a thermoelectric conversion material layer in a thermoelectric conversion element. The presently disclosed shaped product for a thermoelectric conversion element can be produced using a presently disclosed method of producing a shaped product for a thermoelectric conversion element. A presently disclosed thermoelectric conversion element includes a thermoelectric conversion material layer including the presently disclosed shaped product for a thermoelectric conversion element.

(Composition for thermoelectric conversion element)

The presently disclosed composition for a thermoelectric conversion element contains metal nanoparticle-supporting carbon nanotubes, a resin component, and a solvent, and optionally contains other components. By using a shaped product for a thermoelectric conversion element obtained using the presently disclosed composition for a thermoelectric conversion element as a thermoelectric conversion material layer in a thermoelectric conversion element, the thermoelectric conversion element can fully exhibit excellent thermoelectric conversion characteristics.

Although the reason that the presently disclosed composition for a thermoelectric conversion element enables the thermoelectric conversion element to fully exhibit excellent thermoelectric conversion characteristics is not clear, the reason is presumed as follows:

CNTs having such a structure that is obtained by rolling up a graphene sheet (six-membered ring network sheet formed by carbon) into a single-walled or multi-walled cylinder have defect structures (portions where a six-membered ring network is not formed favorably) on their surfaces. It is presumed that, for example with the technique in PTL 1, the presence of the defect structures may make it impossible to achieve sufficient conductivity of CNTs. In view of this, according to the present disclosure, CNTs having such defect structures are made to support metal nanoparticles, thus improving the conductivity of the CNTs. The use of the metal nanoparticle-supporting CNTs as a thermoelectric conversion material layer is expected to considerably enhance the thermoelectric conversion characteristics of the thermoelectric conversion element.

<Metal nanoparticle-supporting carbon nanotubes>

The metal nanoparticle-supporting CNTs are a composite material of CNTs and metal in which metal nanoparticles adhere to the surfaces of CNTs.

[Carbon nanotubes]

The CNTs forming the metal-supporting CNTs may be any of single-walled carbon nanotubes and multi-walled carbon nanotubes. In terms of further enhancing the thermoelectric conversion characteristics of the thermoelectric conversion element, the CNTs preferably include at least either one of single-walled carbon nanotubes and double-walled carbon nanotubes, and preferably include single-walled carbon nanotubes.

The average diameter of the CNTs is preferably 0.5 nm or more, and more preferably 1 nm or more. The CNTs having an average diameter of 0.5 nm or more are prevented from aggregating, so that the thermoelectric conversion characteristics of the thermoelectric conversion element can be further enhanced. No upper limit is placed on the average diameter of the CNTs, but the average diameter of the CNTs is, for example, 15 nm or less.

Herein, the average diameter of the CNTs can be obtained by measuring the diameters of 100 randomly selected carbon nanotubes using a transmission electron microscope.

The average length of the CNTs is preferably 0.1 $\mu$m or more, and is preferably 1 cm or less, and more preferably 3 mm or less. If the average length of the CNTs is in the above-mentioned range, the thermoelectric conversion characteristics of the thermoelectric conversion element can be further enhanced.

Herein, the average length of the CNTs can be obtained by measuring the lengths of 100 randomly selected carbon nanotubes using a transmission electron microscope.

The BET specific surface area of the CNTs is preferably 600 $m^2$/g or more and more preferably 800 $m^2$/g or more, and is preferably 2600 $m^2$/g or less and more preferably 1200 $m^2$/g or less. If the BET specific surface area of the CNTs is in the above-mentioned range, the thermoelectric conversion characteristics of the thermoelectric conversion element can be further enhanced.

The "BET specific surface area" of the CNTs can be obtained through a BET method by measuring a nitrogen adsorption isotherm at 77 K. Measurement of the BET specific surface area can for example be performed using a BELSORP®-max (BELSORP is a registered trademark in Japan, other countries, or both) produced by Bel Japan Inc.

Examples of the method of producing the CNTs used herein include a method of catalytic hydrogen reduction of carbon dioxide, an arc discharge method, a chemical vapor deposition (CVD) method, a laser vaporization method, a vapor growth method, a gas phase flow method, and a HiPCO method, without being limited thereto. The CNTs having the above-mentioned preferable properties can be efficiently produced, for example, according to the method (super growth method, see WO2006/011655) wherein during synthesis of CNTs through CVD by supplying a feedstock compound and a carrier gas onto a substrate having thereon a catalyst layer for carbon nanotube production, the catalytic activity of the catalyst layer is dramatically improved by providing a trace amount of an oxidizing agent (catalyst activating material) in the system. Hereinafter, carbon nanotubes obtained by the super growth method are also referred to as "SGCNTs."

The CNTs may have a functional group such as a carboxyl group or the like introduced. A functional group may be introduced by a known method such as oxidation treatment that uses hydrogen peroxide, nitric acid, or the like or contacting treatment with a supercritical fluid, a subcritical fluid, or a high-temperature, high-pressure fluid.

[Metal nanoparticles]

The average particle diameter of the metal nanoparticles supported by the CNTs is preferably 0.5 nm or more and more preferably 1.0 nm or more, and is preferably 15 nm or less, more preferably 10 nm or less, and further preferably 5.0 nm or less. Metal nanoparticles having an average particle diameter of 0.5 nm or more can be stably formed on the CNTs. If the average particle diameter of the metal nanoparticles is 15 nm or less, they can be easily supported on the defect structures of the CNTs, which increases the defect structure repairing effect. Hence, if the average particle diameter of the metal nanoparticles is in the above-mentioned range, the stable formation of metal nanoparticles and the defect structure repairing effect can both be achieved, and the thermoelectric conversion characteristics of the thermoelectric conversion element can be further enhanced.

The standard deviation of the particle diameters of the metal nanoparticles is preferably 1.5 nm or less. If the standard deviation of the particle diameters of the metal nanoparticles is less than or equal to the above-mentioned value, the thermoelectric conversion characteristics of the thermoelectric conversion element can be further enhanced.

The average particle diameter and the particle diameter standard deviation of the metal nanoparticles can be obtained by measuring the particle diameters of 100 randomly selected metal nanoparticles based on an image thereof observed using a transmission electron microscope.

The metal nanoparticles supported by the CNTs are preferably transition metal nanoparticles, in terms of enhancing conductivity and further improving the thermoelectric conversion characteristics of the thermoelectric conversion element. From the same perspective, the transition metal is more preferably chromium (Cr), manganese (Mn), iron (Fe), cobalt (Co), nickel (Ni), copper (Cu), ruthenium (Ru), rhodium (Rh), palladium (Pd), silver (Ag), tungsten (W), rhenium (Re), iridium (Ir), platinum (Pt), gold (Au), or titanium (Ti), and further preferably palladium. Nanoparticles of palladium can be particularly easily precipitated onto the CNTs by the reduction reaction of palladium ions using the reductant, which contributes to further improved thermoelectric conversion characteristics. One of such transition metals may be used individually, or two or more of such transition metals may be used in combination. Examples of other elements that can constitute the nanoparticles together with such transition metal include magnesium (Mg), calcium (Ca), zinc (Zn), aluminum (Al), gallium (Ga), germanium (Ge), tin (Sn), and antimony (Sb).

Although no specific limitations are placed on the amount of the metal nanoparticles supported in the metal-supporting CNTs, the amount is preferably 1 parts by mass or more and more preferably 5 parts by mass or more and is preferably 100 parts by mass or less and more preferably 30 parts by mass or less relative to 100 parts by mass of the CNTs, when the condition for sufficiently providing the metal nanoparticles on the defect structures to further enhance the thermoelectric conversion characteristics of the thermoelectric conversion element and also the supporting ability of the CNTs and economic factors are taken into consideration.

Herein, the "amount of the metal nanoparticles supported" can be measured using an inductively coupled plasma (ICP) emission spectrophotometer by dissolving the metal-supporting CNTs into nitric acid or aqua regia.

[Method of producing metal nanoparticle-supporting carbon nanotubes]

The metal nanoparticle-supporting CNTs can be produced, for example, by reducing, in a mixture containing CNTs and a metal precursor, the metal precursor to cause metal nanoparticles to precipitate onto the surfaces of the CNTs, and then optionally performing purification. Examples of the method of reducing the metal precursor to cause the metal nanoparticles to precipitate onto the surfaces of the CNTs include:

(1) a method of reducing a metal precursor in a mixture containing CNTs, the metal precursor, a reductant, and optionally a reaction solvent, by the reductant; and
(2) a method of reducing a metal precursor in a mixture containing CNTs, the metal precursor, and a reaction solvent, by dispersion treatment using physical energy that brings about a cavitation effect or a crushing effect.

With the use of the method (1) or (2), the nanoparticles can be selectively adhered to the defect structures of the CNTs. Thus, CNTs supporting metal nanoparticles with excellent conductivity can be produced efficiently.

[[(1) Method of reducing metal precursor by reductant]]

- CNTs -

The CNTs described in the foregoing "Carbon nanotubes" section are used.

- Metal precursor -

The metal precursor is a compound from which the metal nanoparticles can be formed on the surfaces of the CNTs through a reduction reaction. No specific limitations are placed on the metal precursor other than enabling desired metal nanoparticles to be formed through a reduction reaction. Specific examples of metal precursors that can be used include $Pd(CH_3COO)_2$ (palladium acetate), $Pt(NH_3)_2(NO_2)_2$, $(NH_4)_2[RuCl_6]$, $(NH_4)_2[RUCl_5(H_2O)]$, $H_2PtCl_4$, $H_2PtCl_6$, $K_2PtCl_4$, $K_2PtCl_6$, $H_2[AuCl_4]$, $(NH_4)_2[AuCl_4]$, and $H[Au(NO_3)_4]H_2O$. Of these, $Pd(CH_3COO)_2$ is preferable. Any one of these metal precursors or a combination of any two or more of these metal precursors may be used.

- Reductant -

No specific limitations are placed on the reductant other than being a compound capable of reducing the metal precursor. Specific examples of reductants that can be used include N,N-dimethylformamide (DMF), ethanol, hydrazine hydrate, sodium borohydride, and diborane, Of these, an organic solvent-type reductant, such as DMF or ethanol, capable of dispersing or dissolving the CNTs and the metal precursor as a reaction solvent while functioning as a reductant is preferable. Any one of these reductants or a combination of any two or more of these reductants may be used.
In the case of using an organic solvent-type reductant as the reductant, even when the below-mentioned reaction solvent is not used, it is still possible to induce a reduction reaction by dispersing or dissolving the CNTs and the metal precursor in the organic solvent-type reductant and applying energy such as heat, light, microwave, or ultrasound. However, in terms of achieving a favorable dispersion state of the CNTs and the metal precursor in the mixture, it is preferable to use the organic solvent-type reductant and the reaction solvent in combination. The mixing ratio (by mass) of the organic solvent-type reductant and the reaction solvent is not limited, and may be freely determined based on the dispersion state of the CNTs.

- Reaction solvent -

The mixture optionally contains a reaction solvent. No specific limitations are placed on the reaction solvent other than enabling the dissolution or dispersion of the CNTs, the metal precursor, and the reductant. Examples of the reaction solvent include the organic solvents described later as "solvent" usable in the presently disclosed composition for a thermoelectric conversion element, exclusive of those that are equivalent to the above-mentioned reductant. Of these, 1-methyl-2-pyrrolidone (NMP) and dimethyl sulfoxide (DMSO) are preferable. Any one of these reaction solvents or a combination of any two or more of these reaction solvents may be used.

- Mixture -

The CNTs, the metal precursor, the reductant, and optionally the reaction solvent are mixed by a known method, to produce a mixture. The concentration of each component in the mixture may be adjusted as appropriate.

- Reduction reaction by reductant -

The conditions when reducing the metal precursor in the mixture by the reductant are not limited, as long as the reductant can fulfill its function. As an example, in the case of using DMF as the reductant, it is preferable to cause the mixture to react at 70 °C or more and 120 °C or less for 10 minutes or more and 2 hours or less. As another example, in the case of using ethanol as the reductant, it is preferable to cause the mixture to react at 25 °C or more and 78 °C or less for 10 minutes or more and 2 hours or less.
[[(2) Method of reducing metal precursor by dispersion treatment that brings about cavitation effect or crushing effect]]

- CNTs, metal precursor, reaction solvent -

The CNTs, the metal precursor, and the reaction solvent may be the same as those in the foregoing method (1).

- Mixture -

The CNTs, the metal precursor, and the reaction solvent are mixed by a known method, to produce a mixture. The concentration of each component in the mixture may be adjusted as appropriate.

[0055]    - Reduction reaction by dispersion treatment that brings about cavitation effect or crushing effect -

The dispersion treatment that brings about a cavitation effect is a dispersion method that utilizes shock waves caused by the rupture of vacuum bubbles formed in the solvent when high energy is applied to the liquid. This dispersion method can be used to reduce the metal precursor in the mixture to enable favorable precipitation of the metal nanoparticles onto the surfaces of the CNTs.

Specific examples of the dispersion treatment that brings about a cavitation effect include dispersion treatment using ultrasound, dispersion treatment using a jet mill, and dispersion treatment using high-shear stirring. One of these dispersion treatments may be carried out or a plurality of these dispersion treatments may be carried out in combination. More specifically, an ultrasonic homogenizer, a jet mill, and a high-shear stirring device are preferably used. Commonly known conventional devices may be used as these devices.

In a situation in which an ultrasonic homogenizer is used, the mixture is irradiated with ultrasound by the ultrasonic homogenizer. The irradiation time may be set as appropriate in consideration of the amount of CNTs and so forth. For example, the irradiation time is preferably 1 minutes or more and more preferably 2 minutes or more, and is preferably 5 hours or less and more preferably 2 hours or less. For example, the output is preferably 10 W or more and 50 W or less, and the temperature is preferably 0 °C or more and 50 °C or less.

In a situation in which a jet mill is used, the number of treatment repetitions carried out is set as appropriate in consideration of the amount of CNTs and so forth. For example, the number of treatment repetitions is preferably at least 2 repetitions and more preferably at least 5 repetitions, and is preferably no greater than 100 repetitions and more preferably no greater than 50 repetitions. For example, the pressure is preferably 20 MPa or more and 250 MPa or less, and the temperature is preferably 15 °C or more and 50 °C or less.

In a situation in which high-shear stirring is used, the coarse dispersion liquid is subjected to stirring and shearing using a high-shear stirring device. The rotational speed is preferably as fast as possible. The operating time (i.e., the time during which the device is rotating) is preferably 3 minutes or more and 4 hours or less, the circumferential speed is preferably 5 m/sec or more and 50 m/sec or less, and the temperature is preferably 15 °C or more and 50 °C or less.

The dispersion treatment that brings about a cavitation effect is more preferably performed at a temperature of 50 °C or less. This suppresses a change in concentration due to volatilization of the reaction solvent.

The dispersion treatment that brings about a crushing effect is even more advantageous because, in addition to reducing the metal precursor in the mixture to enable favorable precipitation of the metal nanoparticles onto the surfaces of the CNTs, the dispersion treatment that brings about a crushing effect reduces damage to the CNTs due to shock waves when air bubbles burst compared to the above-mentioned dispersion treatment that brings about a cavitation effect.

The dispersion treatment that brings about a crushing effect promotes the reduction reaction favorably by causing crushing and dispersion of aggregates of the CNTs by imparting shear force to the mixture and by further applying back pressure to the mixture, while cooling the mixture as necessary in order to reduce air bubble formation.

When applying back pressure to the mixture, the back pressure may be applied to the mixture by lowering pressure at once to atmospheric pressure, yet the pressure is preferably lowered over multiple steps.

In order to further promote the reduction reaction favorably by applying a shear force to the mixture, a dispersion system including a disperser with the structure below, for example, may be used.

From the side where the mixture flows in to the side where the mixture flows out, the disperser is sequentially provided with a disperser orifice having an inner diameter d1, a dispersion space having an inner diameter d2, and a terminal section having an inner diameter d3 (where d2 > d3 > d1).

In this disperser, by passing through the disperser orifice, high-pressure (e.g. 10 MPa to 400 MPa, preferably 50 MPa to 250 MPa) mixture that flows in is reduced in pressure while becoming a high flow rate fluid that then flows into the dispersion space. Subsequently, the high flow rate mixture that has entered the dispersion space flows in the dispersion space at high speed, receiving a shear force at that time. As a result, the flow rate of the coarse dispersion liquid decreases, and the reduction reaction progresses favorably. A fluid at a lower pressure (back pressure) than the pressure of the in-flowing coarse dispersion liquid then flows out from the terminal section, yielding the dispersion liquid containing the metal-supporting CNTs.

The back pressure of the mixture may be applied to the mixture by applying a load to the flow of the mixture. For example, a desired back pressure may be applied to the mixture by providing a multiple step-down device downstream from the disperser.

With this multiple step-down device, the back pressure of the mixture is lowered over multiple steps, so that when the dispersion liquid containing the metal-supporting CNTs is ultimately released into atmospheric pressure, the occurrence of air bubbles in the dispersion liquid can be suppressed.

The disperser may be provided with a heat exchanger or a cooling liquid supply mechanism for cooling the mixture. The reason is that by cooling the coarse dispersion liquid that is at a high temperature due to the application of a shear force in the disperser, the generation of air bubbles in the mixture can be further suppressed.

Instead of providing a heat exchanger or the like, the generation of air bubbles in the mixture containing the metal-supporting CNTs can also be suppressed by cooling the mixture in advance.

As described above, in this dispersion treatment that brings about a crushing effect, the occurrence of cavitation can be suppressed, thereby suppressing damage to the CNTs due to cavitation, which is sometimes a concern. In particular, damage to the CNTs due to shock waves when the air bubbles burst can be suppressed. Additionally, adhesion of air bubbles to the CNTs and energy loss due to the generation of air bubbles can be suppressed, so that the reduction reaction can progress favorably.

Examples of a dispersion system having the above structure include the product name "BERYU SYSTEM PRO" (manufactured by BeRyu Corporation). Dispersion treatment that brings about a crushing effect may be performed by using such a dispersion system and appropriately controlling the dispersion conditions.

[[Purification of metal nanoparticle-supporting carbon nanotubes]]

After the reduction reaction by the foregoing method (1) or (2), the metal-supporting CNTs can be isolated by optionally performing purification, such as removing the reductant and the reaction solvent from the resultant dispersion liquid and cleaning. The dispersion liquid may be used in the production of the composition for a thermoelectric conversion element directly or after being concentrated. In other words, the reaction solvent used for the reduction reaction may be directly used as the solvent of the composition for a thermoelectric conversion element.

<Resin component>

The resin component is not limited, as long as it is a material capable of withstanding the operating temperature of the thermoelectric conversion element while imparting flexibility to the shaped product for a thermoelectric conversion element. Examples of the resin component include: polyolefins such as polypropylene, high-density polyethylene, low-density polyethylene, linear low-density polyethylene, cross-linked polyethylene, ultra-high molecular weight polyethylene, polybutene-1, poly-3-methylpentene, poly-4-methylpentene, polycycloolefin, ethylene-vinyl acetate copolymer, ethylene-ethyl acrylate copolymer, ethylene-propylene copolymer, and a copolymer of polyethylene and a cyclo-olefin (such as norbornene); halogenated polyolefins such as polyvinyl chloride, polyvinylidene chloride, chlorinated polyethylene, chlorinated polypropylene, polyvinylidene fluoride, chlorinated rubber, vinyl chloride-vinyl acetate copolymer, vinyl chloride-ethylene copolymer, vinyl chloride-vinylidene chloride copolymer, vinyl chloride-vinylidene chloride-vinyl acetate terpolymer, vinyl chloride-acrylic acid ester copolymer, vinyl chloride-maleic acid ester copolymer, and vinyl chloride-cyclohexylmaleimide copolymer; petroleum resin; coumarone resin; polystyrene; polyvinyl acetate; acrylic resins such as polymethyl methacrylate; polyacrylonitrile; styrene-based resins such as AS resin, ABS resin, ACS resin, SBS resin, MBS resin, and heat-resistant ABS resin; polyvinyl alcohol; polyvinyl formal; polyvinyl butyral; polyalkylene terephthalates such as polyethylene terephthalate, polytrimethylene terephthalate, polybutylene terephthalate, and polycyclohexanedimethylene terephthalate; polyalkylene naphthalates such as polyethylene naphthalate and polybutylene naphthalate; liquid-crystal polyester (LCP); degradable aliphatic polyesters such as polyhydroxybutyrate, polycaprolactone, polybutylene succinate, polyethylene succinate, polylactic acid, polymalic acid, polyglycolic acid, polydioxane, and poly(2-oxetanone); polyphenylene oxide; nylon resins such as nylon 6, nylon 11, nylon 12, nylon 6,6, nylon 6,10, nylon 6T, nylon 6I, nylon 9T, nylon M5T, nylon 6,12, nylon MXD6, para-aramids, and meta-aramids; polycarbonate resin; polyacetal resin; polyphenylene sulfide; polyurethane; polyimide resin; polyamide imide resin; polyether ketone resin; polyether ether ketone resin; gum arabic; and cellulose acetate. One of such resin components may be used individually, or two or more of such resin components may be used in combination.

Of these resin components, polyolefins and halogenated polyolefins are preferable, halogenated polyolefins are more preferable, and polyvinyl chloride (PVC) is further preferable, in terms of improving the formability of the shaped product for a thermoelectric conversion element obtained from the composition for a thermoelectric conversion element while enhancing the dispersibility of the metal-supporting CNTs, and also further enhancing the thermoelectric conversion characteristics of the thermoelectric conversion element.

The resin component is preferably resin having insulating capacity (insulating resin). Specifically, the electrical conductivity is preferably 1 $S \cdot cm^{-1}$ or less. The thermal conductivity of the resin component is preferably 0.5 $W \cdot m^{-1} K^{-1}$ or less, and more preferably 0.3 $W \cdot m^{-1} K^{-1}$ or less. The resin component is preferably resin having binding capacity (binding resin).

The electrical conductivity of the resin component can be obtained as follows: After forming a thin film of the resin component and measuring its film thickness, the surface resistivity of the thin film is measured by a resistivity meter such as "Loresta®-GP (MCP-T600 type)" (Loresta is a registered trademark in Japan, other countries, or both) produced by Mitsubishi Chemical Analytech, Co., Ltd., and the electrical conductivity is calculated from the measured film thickness and surface resistivity. The thermal conductivity ($\kappa$) of the resin component can be calculated using thermal diffusivity $\alpha$ (mm$^2$·S$^{-1}$, 25 °C), specific heat Cp (J·g$^{-1}$K$^{-1}$, 25 °C), and density $\rho$ (g·cm$^{-3}$) according to the following formula:

$$\kappa = \alpha \times Cp \times \rho$$

where the thermal diffusivity $\alpha$, the specific heat Cp, and the density $\rho$ can be measured by the following devices or methods:

$\alpha$: nanoFlash analyzer (produced by NETZSCH Japan K.K., LFA 447/2-4/InSb NanoFlash Xe)
Cp: differential scanning calorimeter (produced by NETZSCH Japan K.K., DSC 204 F1 Phoenix)
$\rho$: Archimedean method.

The blending amount of the resin component in the composition for a thermoelectric conversion element is not limited, but is preferably 1 parts by mass or more, more preferably 30 parts by mass or more, further preferably 50 parts by mass or more, particularly rpeferably 100 parts by mass or more, and most preferably 120 parts by mass or more, and is preferably 300 parts by mass or less, more preferably 250 parts by mass or less, further preferably 200 parts by mass or less, and particularly preferably 180 parts by mass or less, relative to 100 parts by mass of the metal-supporting CNTs. If the blending amount of the resin component is in the above-mentioned range, the thermoelectric conversion characteristics of the thermoelectric conversion element can be further enhanced.

<Solvent>

The solvent that can be used in the presently disclosed composition for a thermoelectric conversion element is not limited, as long as it is capable of dissolving and/or dispersing the metal-supporting CNTs and the resin component. The solvent is preferably an organic solvent. Specific examples include: aromatic solvents such as toluene, xylene, ethylbenzene, anisole, trimethylbenzene, p-fluorophenol, p-chlorophenol, o-chlorophenol, and perfluorophenol; ethers such as tetrahydrofuran, dioxane, cyclopentyl monomethyl ether, ethylene glycol monoethyl ether, ethylene glycol monomethyl ether acetate, ethylene glycol monoethyl ether acetate, propylene glycol monomethyl ether acetate, diethylene glycol monobutyl ether acetate, diethylene glycol monoethyl ether acetate, and 3-methoxybutyl acetate; ketones such as cyclohexanone, methyl isobutyl ketone, methyl ethyl ketone, and diisobutyl ketone; nitrogen-containing polar organic solvents such as N,N-dimethylformamide, N,N-dimethylacetamide, N,N-diethylformamide, 2-pyrrolidone, N-methyl-2-pyrrolidone, 1,3-dimethyl-2-imidazolidinone, N,N,N,N-tetramethylurea, N-methyl-e-caprolactum, and hexamethylphosphoric triamide; esters such as ethyl acetate, methyl acetate, n-propyl acetate, isopropyl acetate, n-butyl acetate, n-pentyl acetate, methyl lactate, ethyl lactate, n-butyl lactate, $\gamma$-butyrolactone, and $\gamma$-valerolactone; and dimethyl sulfoxide. One of such solvents may be used individually, or two or more of such solvents may be used in combination. Of these, N-methyl-2-pyrrolidone, N,N-dimethylformamide, and dimethyl sulfoxide are preferable, and N-methyl-2-pyrrolidone is more preferable, in terms of improving the dispersibility of the metal-supporting CNTs.

The blending amount of the solvent in the composition for a thermoelectric conversion element may be adjusted as appropriate depending on the types and amounts of the metal-supporting CNTs, the resin component, and the like.

<Other components>

The presently disclosed composition for a thermoelectric conversion element may contain components other than the above-mentioned metal-supporting CNTs, resin component, and solvent. The other components include, but are not limited to, a polymer transition metal complex, a carbon nanotube dispersant, triphenylphosphine, cellulose, and a known inorganic thermoelectric conversion material used in a thermoelectric conversion material layer.

The polymer transition metal complex is a component capable of facilitating the transport of carriers such as electrons in the thermoelectric conversion element, and is, for example, a salt of poly(M 1,1,2,2-ethene tetra thiolate). Herein, M denotes metal, examples of which include nickel, copper, palladium, cobalt, and iron. Examples of the type of the salt include sodium salt, potassium salt, copper salt, and alkyl ammonium salt (including alkyl ammonium salt obtained by substituting a hydrogen atom of alkyl group by any functional group). As used herein, any component equivalent to the polymer transition metal complex is not included in the above-mentioned resin component.

Examples of the carbon nanotube dispersant include surfactants such as sodium dodecyl sulfonate, sodium deoxycholate, sodium cholate, and sodium dodecylbenzenesulfonate.

The inorganic thermoelectric conversion material is, for example, that material described in JP 2015-170766 A, without being limited thereto.

The blending amounts of these other components may be adjusted as appropriate.

<Method of producing composition for thermoelectric conversion element>

The composition for a thermoelectric conversion element can be produced by mixing the above-mentioned components by a known method, but it is preferable to produce the composition for a thermoelectric conversion element through a step of mixing a coarse mixture that contains metal-supporting CNTs, a resin component, and a solvent by dispersion treatment that brings about a cavitation effect or a crushing effect. By producing the composition for a thermoelectric conversion element using dispersion treatment that brings about a cavitation effect or dispersion treatment that brings about a crushing effect, the metal-supporting CNTs can be dispersed favorably, enabling the thermoelectric conversion element to fully exhibit excellent thermoelectric conversion characteristics.

The dispersion treatment that brings about a cavitation effect may be the same process as that described above in the "Method of producing metal nanoparticle-supporting carbon nanotubes" section. By using this dispersion method, the metal-supporting CNTs can be dispersed favorably.

In a situation in which an ultrasonic homogenizer is used in the mixing of the coarse mixture, for example, the ultrasound irradiation time is preferably 1 minutes or more and more preferably 5 minutes or more, and is preferably 5 hours or less and more preferably 2 hours or less. For example, an output of 20 W or more can fully bring about a cavitation effect. The temperature is preferably 0 °C or more and 50 °C or less.

In a situation in which a jet mill is used in the mixing of the coarse mixture, for example, the number of treatment repetitions carried out is preferably at least 2 repetitions and more preferably at least 5 repetitions, and is preferably no greater than 100 repetitions and more preferably no greater than 50 repetitions. For example, the pressure is preferably 20 MPa or more and 250 MPa or less, and the temperature is preferably 0 °C or more and 50 °C or less.

In a situation in which high-shear stirring is used in the mixing of the coarse mixture, for example, the rotational speed is preferably as fast as possible. The operating time (i.e., the time during which the device is rotating) is preferably 3 minutes or more and 4 hours or less, the circumferential speed is preferably 5 m/sec or more and 50 m/sec or less, and the temperature is preferably 15 °C or more and 50 °C or less.

The dispersion treatment that brings about a cavitation effect is more preferably performed at a temperature of 50 °C or less. This suppresses a change in concentration due to volatilization of the solvent.

The dispersion treatment that brings about a crushing effect may be the same process as that described above in the "Method of producing metal nanoparticle-supporting carbon nanotubes" section. The dispersion treatment that brings about a crushing effect is even more advantageous because, in addition to enabling uniform dispersion of the metal-supporting CNTs in the solvent, the dispersion treatment that brings about a crushing effect reduces damage to the metal-supporting CNTs due to shock waves when air bubbles burst compared to the above-mentioned dispersion treatment that brings about a cavitation effect.

The dispersion treatment that brings about a crushing effect is preferably performed using the dispersion system having a disperser of the structure described above in the "Method of producing metal nanoparticle-supporting carbon nanotubes" section.

(Shaped product for thermoelectric conversion element)

The presently disclosed shaped product for a thermoelectric conversion element can be formed, for example, by removing at least part of the solvent from the presently disclosed composition for a thermoelectric conversion element. The shaped product for a thermoelectric conversion element obtained in this way contains at least the metal nanoparticle-supporting CNTs and the resin component, and optionally contains components described above as the "other components" in the "Composition for thermoelectric conversion element" section. The preferred ratio of these components in the shaped product for a thermoelectric conversion element is the same as that in the composition for a thermoelectric conversion element. Since the presently disclosed shaped product for a thermoelectric conversion element is formed using the presently disclosed composition for a thermoelectric conversion element, by using the shaped product for a thermoelectric conversion element as a thermoelectric conversion material layer, the thermoelectric conversion element can fully exhibit excellent thermoelectric conversion characteristics.

The shape of the shaped product for a thermoelectric conversion element is not limited as long as it is usable as a thermoelectric conversion material layer in a thermoelectric conversion element, but a film shape is preferable. The thickness of the shaped product for a thermoelectric conversion element is preferably 0.05 $\mu$m or more, more preferably 0.1 µm or more, and further preferably 1 µm or more, and is preferably 100 µm or less, more preferably 10 µm or less, and further preferably 5 µm or less. If the thickness of the shaped product for a thermoelectric conversion element is 0.05 µm or more, the strength of the shaped product for a thermoelectric conversion element can be ensured. If the thickness of the shaped product for a thermoelectric conversion element is 100 µm or less, the thermoelectric conversion characteristics of the thermoelectric conversion element can be further improved. This is presumed to be because improvement in the orientation of the metal-supporting CNTs in the planar direction leads to an increase in electrical conductivity. Particularly in the case where the thickness of the shaped product for a thermoelectric conversion element is 5 µm or less, the thermoelectric conversion characteristics of the thermoelectric conversion element are greatly improved. This is presumed to be because, with the thickness of the shaped product for a thermoelectric conversion element being 5 µm or less, the tilt angle of the metal-supporting CNTs is approximately 0°, which contributes to significantly improved orientation in the planar direction.

(Method of producing shaped product for thermoelectric conversion element)

The presently disclosed shaped product for a thermoelectric conversion element described above can be produced using the presently disclosed method of producing a shaped product for a thermoelectric conversion element. Specifically, the presently disclosed method of producing a shaped product for a thermoelectric conversion element includes: a step of mixing a coarse mixture that contains metal nanoparticle-supporting carbon nanotubes, a resin component, and a solvent by dispersion treatment that brings about a cavitation effect or a crushing effect, to obtain a composition for a thermoelectric conversion element (step of producing a composition for a thermoelectric conversion element); and a step of removing the solvent from the composition for a thermoelectric conversion element (solvent removal step). Since the presently disclosed method of producing a shaped product for a thermoelectric conversion element uses the presently disclosed composition for a thermoelectric conversion element and also employs, in the production of the composition, the dispersion treatment that brings about a cavitation effect or a crushing effect, the production method can yield a shaped product for a thermoelectric conversion element that enables a thermoelectric conversion element to fully exhibit excellent thermoelectric conversion characteristics.

<Step of producing composition for thermoelectric conversion element>

As described above in the "Composition for thermoelectric conversion element" section, the composition for a thermoelectric conversion element can be produced using the dispersion treatment that brings about a cavitation effect or a crushing effect.

<Solvent removal step>

The method of removing the solvent from the composition for a thermoelectric conversion element to form a shaped product for a thermoelectric conversion element is not limited. For example, a shaped product for a thermoelectric conversion element in film shape can be produced by supplying the composition for a thermoelectric conversion element onto a substrate by applying, casting, or the like and then removing the solvent from the film of the composition for a thermoelectric conversion element formed on the substrate.
The substrate to which the composition for a thermoelectric conversion element is applied may be a known substrate, such as that described in JP 2014-199837 A.
No specific limitations are placed on the method of removing the solvent from the film of the composition for a thermoelectric conversion element, and examples of methods that can be used include a method in which the film is heated and a method in which the film is placed in a reduced pressure atmosphere at room temperature or under heating. The corresponding conditions may be set as appropriate.
Furthermore, the shaped product for a thermoelectric conversion element formed by the method described above may be subjected to treatment in which the shaped product for a thermoelectric conversion element is brought into contact with a treatment liquid such as an organic solvent, a saccharide aqueous solution, an acid-containing aqueous solution, or a base-containing aqueous solution. The electrical conductivity of the shaped product for a thermoelectric conversion element can be improved as a result of this treatment. Typically, the treatment liquid is selected so as not to cause swelling or degradation of the shaped product. No specific limitations are placed on the method by which the shaped product and the treatment liquid are brought into contact, and examples of methods that can be used include a method in which the treatment liquid is applied onto the shaped product and a method in which the shaped product is immersed in the treatment liquid.
Examples of suitable organic solvents that can be used as the treatment liquid include: aliphatic alcohols such as methanol, ethanol, n-propanol, isopropanol, n-butanol, n-pentanol, n-hexanol, ethylene glycol, propylene glycol, diethylene glycol, and glycerin; aromatic solvents such as toluene, xylene, and ethylbenzene; and ethers such as diethyl ether, di-n-propyl ether, dioxane, and tetrahydrofuran. Examples of suitable saccharide aqueous solutions that can be used include aqueous solutions of glucose and xylitol. Examples of suitable acid-containing aqueous solutions or base-containing aqueous solutions that can be used include aqueous solutions containing hydrochloric acid and sulfuric acid.

(Thermoelectric conversion element)

The presently disclosed thermoelectric conversion element includes a thermoelectric conversion material layer including the presently disclosed shaped product for a thermoelectric conversion element. The structure of the thermoelectric conversion element is not limited, and a known structure may be used. For example, the thermoelectric conversion element can be produced by attaching two electrodes to the thermoelectric conversion material layer on a substrate. The electrodes are not limited, and may be, for example, that described in JP 2014-199837 A. The positional relationships between the thermoelectric conversion material layer and the two electrodes are not limited. For example, the electrodes may be located at both ends of the thermoelectric conversion material layer, or the thermoelectric conversion material layer may be interposed between the two electrodes.

The presently disclosed thermoelectric conversion element may be used in a thermoelectric conversion module including a plurality of thermoelectric conversion elements. For example, the thermoelectric conversion module is a thermoelectric conversion module formed by combining a plurality of thermoelectric conversion elements in a plate shape or a cylinder shape, where at least one of the plurality of thermoelectric conversion elements is the presently disclosed thermoelectric conversion element. Since the thermoelectric conversion module includes the presently disclosed thermoelectric conversion element, the thermoelectric conversion module is capable of highly efficient electricity generation.

EXAMPLES

The following provides a more specific description of the present disclosure based on examples. However, the present disclosure is not limited to the following examples.
A shaped product for a thermoelectric conversion element obtained in each of the examples and comparative examples was evaluated and analyzed by the following methods.

<Electrical conductivity and power factor (PF)>

The Seebeck coefficient $S(\mu V \cdot K^{-1})$ and electrical conductivity $\sigma$ $(S \cdot cm^{-1})$ of the shaped product for a thermoelectric conversion element at a temperature of 50 °C to 110 °C in a vacuum with a temperature difference of about 1 °C to 5 °C were measured using a thermoelectric characteristic evaluation device (produced by ADVANCE RIKO, Inc., ZEM-3). The power factor $(\mu W \cdot m^{-1} \cdot K^{-2})$ was then calculated using the following formula:

$$PF = S^2 \times \sigma/10000.$$

The power factor is an index representing electric power generation per temperature change, and a higher power factor indicates better thermoelectric conversion characteristics,

(Example 1)

<Production of carbon nanotubes>

CNTs (SGCNTs, including single-walled CNTs, average diameter: 3.5 nm, average length: 0.3 mm, specific surface area: 1000 $m^2$/g) were prepared by a super growth method in accordance with the contents of WO 2006/011655.

<Production of metal nanoparticle-supporting CNTs>

The above-mentioned carbon nanotubes and palladium acetate as a metal precursor were dispersed or dissolved into a mixed solvent of DMF as a reductant and NMP as a reaction solvent (mixing ratio (by mass) of DMF:NMP = 1:1), to obtain a mixture. In the mixture, the CNT concentration was 0.35 mg/mL, and the palladium acetate concentration was 1.4 mM. The resultant mixture was held at 100 °C for 45 minutes, to promote the reduction reaction of the metal precursor. The mixture after the reaction was subjected to suction filtration, and then a residue obtained on filter paper was cleaned with methanol and NMP and further dried at 70 °C for 300 minutes. After the drying, it was confirmed using a transmission electron microscope (TEM) that CNTs supporting palladium nanoparticles (metal-supporting CNTs-1) were obtained. The palladium nanoparticles supported by the CNTs had an average particle diameter of 2.3 nm, and a particle diameter standard deviation of 0.7 nm. It was confirmed using a TEM that the palladium nanoparticles were selectively supported in parts that were considered to be the defect structure portions of the CNTs.

<Production of composition for thermoelectric conversion element>

3.37 mg (100 parts by mass) of the resultant metal nanoparticle-supporting CNTs, 4.50 mg (134 parts by mass) of polyvinyl chloride (PVC) as a resin component, and 3.0 mL of NMP as a solvent were charged into a 6 mL screw vial, and subjected to dispersion treatment for 10 minutes by an ultrasonic bath (produced by Taitec Corporation) and for 10 minutes by an ultrasonic homogenizer (produced by Branson Ultrasonics, Emerson Japan, Ltd.), to obtain a composition for a thermoelectric conversion element.

<Production of shaped product for thermoelectric conversion element>

The resultant composition for a thermoelectric conversion element was applied onto a polyimide substrate, and then the substrate was heated at 60 °C for 12 hours and at 130 °C for 0.5 hours to dry the composition for a thermoelectric conversion element on the substrate, thus obtaining a shaped product for a thermoelectric conversion element in film shape (thickness: 3.3 mm). The measurements were then performed. The results are shown in Table 1.

(Example 2)

<Production of metal nanoparticle-supporting CNTs>

The above-mentioned carbon nanotubes and palladium acetate as a metal precursor were dispersed or dissolved into NMP as a reaction solvent, to obtain a mixture. In the mixture, the CNT concentration was 1.21 mg/mL, and the palladium acetate concentration was 2.0 mM. The resultant mixture was cooled to 0 °C, and simultaneously subjected to dispersion treatment that brings about a cavitation effect using an ultrasonic homogenizer (produced by Branson Ultrasonics, Emerson Japan, Ltd.) with an output of 20 W for 3 minutes, to promote the reduction reaction of the metal precursor. The mixture after the reaction was subjected to suction filtration, and then a residue obtained on filter paper was cleaned with methanol and NMP and further dried at 70 °C for 300 minutes. After the drying, it was confirmed using a TEM that CNTs supporting palladium nanoparticles (metal-supporting CNTs-2) were obtained. The palladium nanoparticles supported by the CNTs had an average particle diameter of 2.1 nm, and a particle diameter standard deviation of 0,5 nm. It was confirmed using a TEM that the palladium nanoparticles were selectively supported in the defect structure portions of the CNTs.

<Production of composition for thermoelectric conversion element and shaped product for thermoelectric conversion element>

A composition for a thermoelectric conversion element and a shaped product for a thermoelectric conversion element (thickness: 3.1 mm) were produced in the same way as in Example 1, except that the metal-supporting CNTs-2 obtained as described above were used instead of the metal-supporting CNTs-1. The measurements were then performed. The results are shown in Table 1.

(Example 3)

Metal nanoparticle-supporting CNTs, a composition for a thermoelectric conversion element, and a shaped product for a thermoelectric conversion element were produced in the same way as in Example 1, except that the thickness of the shaped product for a thermoelectric conversion element was changed as shown in Table 1. The measurements were then performed. The results are shown in Table 1. The thickness of the shaped product for a thermoelectric conversion element was adjusted by changing the amount of the composition for a thermoelectric conversion element applied onto the polyimide substrate.

(Comparative Example 1)

A composition for a thermoelectric conversion element and a shaped product for a thermoelectric conversion element were produced in the same way as in Example 1, except that single-walled carbon nanotubes not supporting metal nanoparticles (CNTs-3, produced by Meijo Nano Carbon., eDIPS (product name), average diameter: 1.4 nm, average length: 0.1 mm, specific surface area: 500 $m^2/g$) were used instead of the metal-supporting CNTs-1 in the production of the composition for a thermoelectric conversion element. The measurements were then performed. The results are shown in Table 1.

(Comparative Example 2)

Carbon nanotubes (CNTs-4, SGCNTs, including single-walled CNTs, average diameter: 3.5 nm, average length: 0.3 mm, specific surface area: 1000 $m^2$/g), polyvinyl chloride as a resin component, and NMP as a solvent were mixed. The resultant mixed liquid and a NMP dispersion liquid of palladium nanoparticles (average particle diameter: 6.3 nm) were charged into a 6 mL screw vial so that the mixing ratio (by mass) of the carbon nanotubes, the resin component, the palladium nanoparticles, and the NMP was the same as that in Example 1, and subjected to dispersion treatment for 10 minutes by an ultrasonic bath (produced by Taitec Corporation) and for 10 minutes by an ultrasonic homogenizer (produced by Branson Ultrasonics, Emerson Japan, Ltd.), to obtain a composition for a thermoelectric conversion element. It was confirmed using a TEM that the palladium nanoparticles were not supported by the CNTs. A shaped product for a thermoelectric conversion element was produced in the same way as in Example 1, and the measurements were performed. The results are shown in Table 1.

[Table 1]

| | CNTs used | Metal nanoparticles supported or not | Metal nanoparticles | | Thickness of shaped product for thermoelectric conversion element ($\mu$m) | PF ($\mu$W/mK$^2$) | $\sigma$ (S/cm) |
| | | | Type | Average particle diameter (nm) | | | |
|---|---|---|---|---|---|---|---|
| Example 1 | Metal-supporting CNTs-1 | Supported | Pd | 2.3 | 3.3 | 38 | 120.1 |
| Example 2 | Metal-supporting CNTs-2 | Supported | Pd | 2.1 | 3.1 | 39 | 111.9 |
| Example 3 | Metal-supporting CNTs-1 | Supported | Pd | 2.3 | 13.1 | 25 | 75.1 |
| Comparative Example I | CNTs-3 | Not supposed | - | - | 3.3 | 22 | 69.2 |
| Comparative Example 2 | CNTs-4 | Not supported | Pd | 6.3 | 3.3 | 31 | 93 |

As can be understood from Table 1, in each of Examples 1 to 3 using metal nanoparticle-supporting CNTs, a shaped product for a thermoelectric conversion element with an excellent power factor (PF) was obtained. The use of the shaped product for a thermoelectric conversion element as a thermoelectric conversion material layer enables a thermoelectric conversion element to fully exhibit excellent thermoelectric conversion characteristics.

In Comparative Example 1 using CNTs not supporting metal nanoparticles, the value of the power factor (PF) was low. Hence, the thermoelectric conversion characteristics of the thermoelectric conversion element cannot be ensured sufficiently, as compared with Examples 1 to 3.

In Comparative Example 2 using CNTs not supporting metal nanoparticles and blending metal nanoparticles in a shaped product for a thermoelectric conversion element, the value of the power factor (PF) was lower than that of Example 1 with the same shaped product thickness. Thus, merely using metal nanoparticles and CNTs together does not have a sufficient thermoelectric conversion characteristic improving effect, and a desired thermoelectric conversion characteristic improving effect can be achieved by metal nanoparticles being supported by CNTs.

INDUSTRIAL APPLICABILITY

It is therefore possible to provide a composition for a thermoelectric conversion element that enables a thermoelectric conversion element to fully exhibit excellent thermoelectric conversion characteristics.

It is also possible to provide a method of producing metal nanoparticle-supporting carbon nanotubes that enables a thermoelectric conversion element to fully exhibit excellent thermoelectric conversion characteristics.

It is also possible to provide a shaped product for a thermoelectric conversion element that enables a thermoelectric conversion element to fully exhibit excellent thermoelectric conversion characteristics.

It is also possible to provide a thermoelectric conversion element having fully excellent thermoelectric conversion characteristics.

**Claims**

1.  A composition for a thermoelectric conversion element, comprising:

    metal nanoparticle-supporting carbon nanotubes;
    a resin component; and
    a solvent.

2.  The composition for a thermoelectric conversion element according to claim 1,
    wherein a specific surface area of carbon nanotubes forming the metal nanoparticle-supporting carbon nanotubes is 600 m$^2$/g or more.

3.  The composition for a thermoelectric conversion element according to claim 1 or 2,
    wherein metal nanoparticles supported by carbon nanotubes in the metal nanoparticle-supporting carbon nanotubes include nanoparticles of transition metal.

4.  The composition for a thermoelectric conversion element according to claim 3,
    wherein the transition metal is palladium.

5.  A method of producing metal nanoparticle-supporting carbon nanotubes, comprising
    reducing a metal precursor in a mixture that contains at least carbon nanotubes, the metal precursor, and a reductant by the reductant, to obtain metal nanoparticle-supporting carbon nanotubes.

6.  A method of producing metal nanoparticle-supporting carbon nanotubes, comprising
    reducing a metal precursor in a mixture that contains at least carbon nanotubes, the metal precursor, and a reaction solvent by dispersion treatment that brings about a cavitation effect or a crushing effect, to obtain metal nanoparticle-supporting carbon nanotubes.

7.  A shaped product for a thermoelectric conversion element formed using the composition for a thermoelectric conversion element according to any of claims 1 to 4.

8.  The shaped product for a thermoelectric conversion element according to claim 7, having a thickness of 0.05 μm or more and 100 μm or less.

9.  A method of producing a shaped product for a thermoelectric conversion element, comprising:

    mixing a coarse mixture that contains metal nanoparticle-supporting carbon nanotubes, a resin component, and a solvent by dispersion treatment that brings about a cavitation effect or a crushing effect, to obtain a composition for a thermoelectric conversion element; and
    removing the solvent from the composition for a thermoelectric conversion element.

10. A thermoelectric conversion element, comprising
    a thermoelectric conversion material layer including the shaped product for a thermoelectric conversion element according to claim 7 or 8.

## INTERNATIONAL SEARCH REPORT

| International application No. |
|---|
| PCT/JP2017/001092 |

**A. CLASSIFICATION OF SUBJECT MATTER**

*H01L35/22*(2006.01)i, *B82Y30/00*(2011.01)i, *B82Y40/00*(2011.01)i, *C01B32/152* (2017.01)i, *C01B32/158*(2017.01)i, *H01L35/24*(2006.01)i, *H01L35/26*(2006.01)i, *H01L35/34*(2006.01)i, *H01L51/00*(2006.01)i, *H01L51/30*(2006.01)i,

**B. FIELDS SEARCHED**

Minimum documentation searched (classification system followed by classification symbols)

H01L35/22, B82Y30/00, B82Y40/00, C01B32/152, C01B32/158, H01L35/24, H01L35/26, H01L35/34, H01L51/00, H01L51/30, H01L51/40

Documentation searched other than minimum documentation to the extent that such documents are included in the fields searched
    Jitsuyo Shinan Koho          1922-1996   Jitsuyo Shinan Toroku Koho   1996-2017
    Kokai Jitsuyo Shinan Koho    1971-2017   Toroku Jitsuyo Shinan Koho   1994-2017

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X<br>Y | JP 2015-228498 A  (Samsung Electronics Co., Ltd.),<br>17 December 2015 (17.12.2015),<br>paragraphs [0020] to [0061]; fig. 1 to 13<br>& US 2015/0342523 A1<br>paragraphs [0060] to [0123]<br>& KR 10-2015-0137889 A  & CN 105280803 A | 1,3-4,7-8,10<br>2-4,7-10 |
| Y | WO 2015/115670 A1  (Nippon Zeon Co., Ltd.),<br>06 August 2015 (06.08.2015),<br>paragraph [0030]<br>& US 2016/0340193 A1<br>paragraphs [0044] to [0045]<br>& EP 3103901 A1          & CN 105934543 A<br>& KR 10-2016-0110401 A | 2-4,7-8,10 |

☒ Further documents are listed in the continuation of Box C.    ☐ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered   to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 28 February 2017 (28.02.17) | 07 March 2017 (07.03.17) |

| Name and mailing address of the ISA/<br>    Japan Patent Office<br>    3-4-3,Kasumigaseki,Chiyoda-ku,<br>    Tokyo 100-8915,Japan | Authorized officer<br><br><br>Telephone No. |
|---|---|

Form PCT/ISA/210 (second sheet) (January 2015)

## INTERNATIONAL SEARCH REPORT

| International application No. |
|---|
| PCT/JP2017/001092 |

C (Continuation).   DOCUMENTS CONSIDERED TO BE RELEVANT

| Category* | Citation of document, with indication, where appropriate, of the relevant passages | Relevant to claim No. |
|---|---|---|
| X | JP 2009-117340 A  (Samsung Electro Mechanics Co., Ltd.), 28 May 2009 (28.05.2009), paragraphs [0014] to [0038]; fig. 1 to 5 & US 2009/0114425 A1 paragraphs [0021] to [0045] & KR 10-2009-0047328 A | 5 |
| X | WO 2015/098089 A1  (Nippon Zeon Co., Ltd.), 02 July 2015 (02.07.2015), paragraphs [0019] to [0068], [0086] to [0097] & US 2016/0315331 A1 paragraphs [0022] to [0099], [0130] to [0152] & EP 3089247 A1        & CN 105814721 A & KR 10-2016-0102406 A  & TW 201539852 A | 5-6 |
| Y | JP 2015-145438 A  (Nippon Zeon Co., Ltd.), 13 August 2015 (13.08.2015), paragraphs [0042] to [0057] (Family: none) | 9 |
| A | JP 2011-236095 A  (Satoshi OHARA), 24 November 2011 (24.11.2011), (Family: none) | 5-6,9 |
| A | JP 2006-334527 A  (University of Tsukuba), 14 December 2006 (14.12.2006), (Family: none) | 5-6,9 |
| A | JP 2015-210955 A  (Nippon Zeon Co., Ltd.), 24 November 2015 (24.11.2015), (Family: none) | 5-6,9 |

Form PCT/ISA/210 (continuation of second sheet) (January 2015)

**INTERNATIONAL SEARCH REPORT**

International application No.

PCT/JP2017/001092

Continuation of A. CLASSIFICATION OF SUBJECT MATTER
  (International Patent Classification (IPC))

H01L51/40(2006.01)i

              (According to International Patent Classification (IPC) or to both national
              classification and IPC)

Form PCT/ISA/210 (extra sheet) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2015170766 A
- WO 2006011655 A
- JP 2014199837 A